# EUROPEAN PATENT APPLICATION

(11) **EP 2 075 934 A2**
(43) Date of publication of application: **01.07.2009**
(21) Application number: 08158962.4
(22) Date of filing: 25.06.2008
(51) Int. Cl.: H04H 40/90

(54) **Apparatus and method for controlling burst gain in bi-directional dead spot**

(30) Priority: 18.12.2007 KR 20070133280
(71) Applicant: Electronics and Telecommunications Research Institute, Yuseong-gu Daejon 305-350 (KR)
(72) Inventor: Ryu, Joon-Gyu, 302-230, Daejon (KR); Han, Sung-Min, 300-020, Daejon (KR); Shin, Minsu, 305-330, Daejon (KR); Chang, Dae-Ig, 302-280, Daejon (KR); Lee, Ho-Jin, 305-390, Daejon (KR)
(74) Representative: Betten & Resch

(57) **Abstract**

Provided is an apparatus and method for controlling a burst gain in a bi-directional dead spot. The apparatus includes a transmission block for creating a burst signal for transmission data; a pilot creating block for creating a pilot signal located outside a use frequency band of the mobile terminal where the pilot signals have different frequencies according to the direction of the mobile terminal; and a multiplexing block for multiplexing and transmitting the burst signal and the pilot signal to a gap filler.

## Description

### CROSS-REFERENCE(S) TO RELATED APPLICATIONS

The present invention claims priority of Korean Patent Application No. 10-2007-0133280, filed on December 18, 2007, which is incorporated herein by reference.

### BACKGROUND OF THE INVENTION

### Field of the Invention

The present invention relates to an apparatus and method for controlling a burst gain in a bi-directional dead spot; and, more particularly, to a burst gain control apparatus which can efficiently compensate for signal attenuation of all signals transmitted from two mobile terminals even in an environment where up and down moving objects, e.g., up and down trains, coexist in the dead spot such as a tunnel since up and down mobile terminals use pilot signals having different frequencies in a bi-directional communication system, especially in a bi-directional satellite communication system.

This work was supported by the IT R&D program for MIC/IITA [2006-S-020-02, "Development of Satellite and Terrestrial Convergence Technology for Internet Service on High-speed Mobile Vehicles"].

### Description of Related Art

Generally, a satellite communication system transmits a continuous signal based on Digital Video Broadcasting - Satellite (DVB-S) on a path from a satellite to a terminal, i.e., a down-link, and transmits a burst signal based on Digital Video Broadcasting-Return Channel via Satellite (DVB-RCS) standard on a path from the terminal to the satellite, i.e., an up-link.

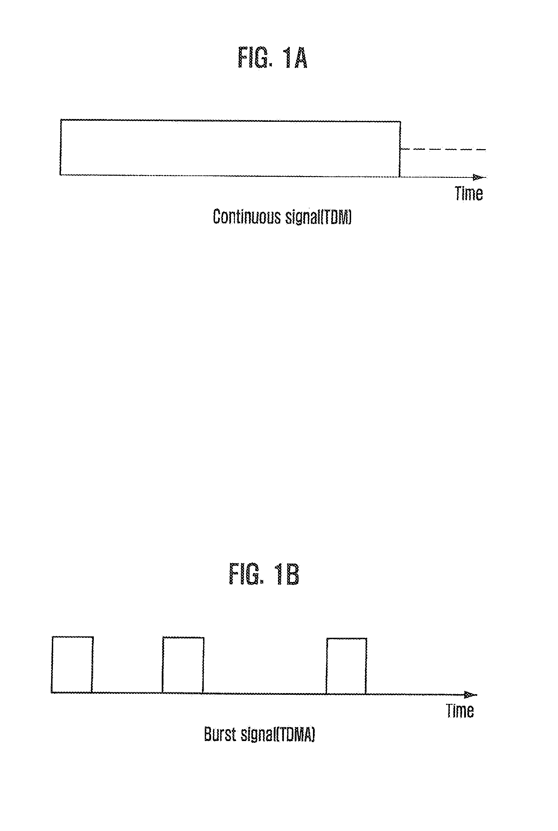

Referring to Fig. 1A, Time Division Multiplexing (TDM) signal transmitted from the satellite to the terminal is a signal continuously existing on a time axis, i.e., a continuous signal. The strength of the inputted signal is detected and compared with that of a reference signal. Signal attenuation can be compensated through an Automatic Gain Control (AGC) method using general feedback of increasing the strength of the signal when the strength of the inputted signal is smaller than that of the reference signal, and decreasing the strength of the signal when the strength of the inputted signal is smaller than that of the reference signal.

On the contrary, referring to Fig. 1B, a Time Division Multiple Access (TDMA) signal transmitted from the terminal to the satellite corresponds to a burst signal which does not continuously exist on the time axis due to a short signal length. Although the TDMA signal appears randomly, it is not possible to compensate for the TDMA signal by the AGC method using the general feedback due to the short signal length.

In a conventional method for solving the problem, the gain can be controlled using a preamble in a receiving part by transmitting a burst signal whose preamble length is increased as much as an AGC response time. However, a problem is that efficiency of data transmission decreases due to unnecessary increase of the preamble length.

Although direct communication between the satellite and the terminal is general in the satellite communication system, a repeater, which is called a gap filler hereinafter, is used for normal communication in an area where direct communication between the satellite and the terminal is not possible, e.g., a tunnel or an underground.

Generally, satellite communication is performed in a status where line of sight (LOS) is secured. Some satellite broadcastings such as a satellite DMB recently applies a gap filler technology to receive satellite broadcasting under a Non-LOS (NLOS) environment.

To be specific, the gap filler located inside the tunnel receives a Ku/Ka band signal from the satellite, performs frequency conversion into an ISM band on the Ku/Ka band signal, and transmits the converted signal to the terminal. The terminal transmits the burst signal to the repeater based on the DVB-RCS standard. The terminal generally includes a set-top box for interactive satellite communication.

Great signal attenuation is applied to the signal transmitted from the terminal to the repeater inside the tunnel, i.e., the burst signal, inside the tunnel. For example, when 2.4GHz band is used in the tunnel, great signal attenuation of about 100dB/km is generated in the signal generated between the repeater and the terminal.

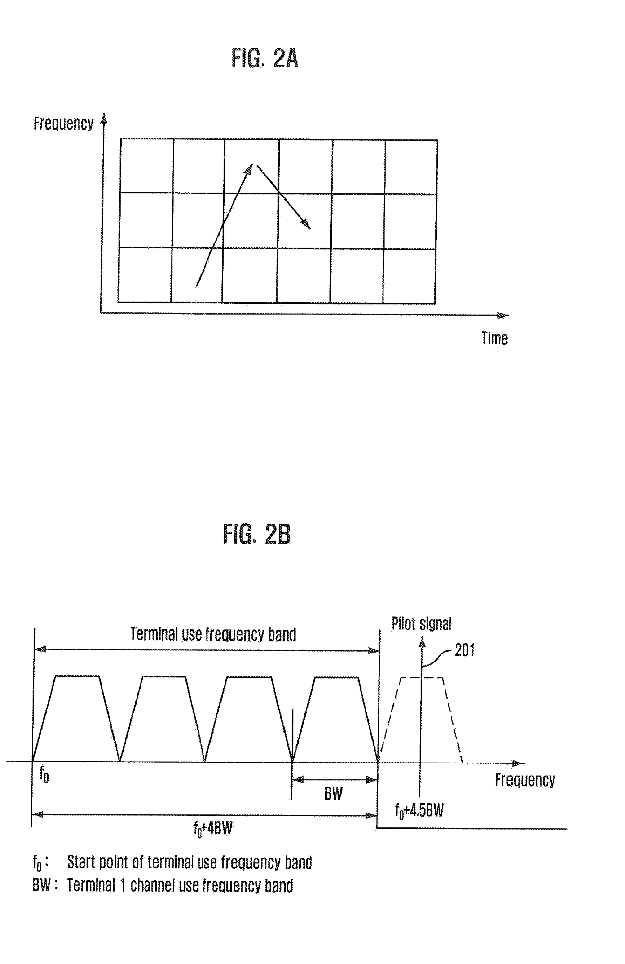

Therefore, the repeater is required to efficiently compensate for attenuation of the burst signal transmitted from the terminal and transmit the burst signal to the satellite such that the terminal inside the tunnel smoothly communicate with the satellite through the repeater. In order to efficiently compensate for attenuation of the burst signal, when the burst signal is transmitted to the gap filler installed inside the tunnel in the terminal, the burst signal may be transmitted by inserting a single-tone pilot signal shown in Fig. 2B, thus causing a problem as follows.

When communication is performed using a gap filler in a satellite mobile communication under a fading environment such as a tunnel, e.g., a railway and a subway, each frequency component having different time differences due to effects of the multi-path inside the tunnel arrives at destinations including the gap filler and the mobile terminal. That is, it is possible to have fadings which are different from each other between frequency components even in the same signal.

Coherence bandwidth (Bc) is the maximum bandwidth between frequency components having the same time delay. A narrowband system represents a system using a bandwidth narrower than the coherence bandwidth and a wideband system represents a system using a bandwidth wider than the coherence bandwidth.

In the DVB-RCS, as shown in Fig. 2A, it is clearly stated that a frequency band of one burst signal is smaller than coherence bandwidth but a band for frequency hopping is 20MHz larger than the standard such that a system for improving resources through fast frequency hopping can be realized.

When a terminal located in a train inserts a single tone 201 of Fig. 2B into a burst signal and transmits the single tone 201 in case where only one train passes through a tunnel, signal attenuation in the dead spot such as the tunnel can be compensated.

When the up and down terminals simultaneously transmit the single tone 201 of Fig. 2B in case where the up and down trains simultaneously pass through the tunnel, a gap filler receiving the single tone 201 controls a burst signal gain based on a pilot signal having a stronger pilot, i.e., a pilot signal transmitted from a train closest to the gap filler inside the tunnel.

In this case, since the signal transmitted from the train does not acquire enough gain, there is a problem that performance is deteriorated due to low signal strength in case where the gap filler transmits the signal.

### SUMMARY OF THE INVENTION

An object of the present invention is to solve the problem that enough gain compensation is not performed with respect to a signal transmitted from a terminal away from a gap filler inside a tunnel in a circumstance that up and down moving objects coexist in a dead spot such as the tunnel when the terminals located at the up and down moving objects, e.g., a train, transmit a single tone of the same frequency for gain control of the burst signal.

The objects of the present invention are not limited to the above-mentioned ones. Other objects and advantages of the present invention can be understood by the following description, and become apparent with reference to the embodiments of the present invention. Also, it is obvious to those skilled in the art to which the present invention pertains that the objects and advantages of the present invention can be realized by the means as claimed and combinations thereof.

In order to solve the above problem, the present invention controls the gain of the burst signal by using pilot signals of different frequencies in the up mobile terminal and the down mobile terminal of the bi-directional communication system and by using down-line and up-line pilot signals in the gap filler.

In accordance with an aspect of the present invention, there is provided an apparatus for controlling a burst gain in a mobile terminal, including: a transmission block for creating a burst signal for transmission data; a pilot creating block for creating a pilot signal located outside a use frequency band of the mobile terminal where the pilot signals have different frequencies according to the direction of the mobile terminal; and a multiplexing block for multiplexing and transmitting the burst signal and the pilot signal to a gap filler.

In accordance with another aspect of the present invention, there is provided an apparatus for controlling a burst gain in a gap filler, including: a burst gain control block for receiving a transmission signal including a burst signal and a pilot signal having frequencies, which are different according to a moving direction, from a plurality of mobile terminals and individually controlling the gain of the burst signal based on each pilot signal; and a combining block for combining a plurality of burst signals after individual gain control in the burst gain control block.

In accordance with another aspect of the present invention, there is provided a method for controlling a burst gain in a mobile terminal, including: creating a burst signal for transmission data; creating a pilot signal located outside a use frequency band of the mobile terminal where the pilot signal has different frequencies according to the direction of the mobile terminal; and multiplexing and transmitting the burst signal and the pilot signal to a gap filler.

In accordance with another aspect of the present invention, there is provided a method for controlling a burst gain in a gap filler, including: receiving a transmission signal including a burst signal and a pilot signal having different frequencies according to a mobile direction from a plurality of mobile terminals; individually controlling the gain of the burst signal based on each pilot signal; and combining a plurality of burst signals after gain control.

### BRIEF DESCRIPTION OF THE DRAWINGS

Figs. 1A and 1B show a continuous signal and a burst signal in Digital Video Broadcasting-Return Channel via Satellite (DVB-RCS).

Fig. 2A shows frequency hopping in DVB-RCS.

Fig. 2B shows a method for controlling the gain of the burst signal based on a single-tone pilot signal.

Fig. 3 shows a pilot signal divided into an up-line pilot signal and a down-line pilot signal inside a tunnel in accordance with an embodiment of the present invention.

Fig. 4 shows a gap filler divided into an up-line gap filler and a down-line gap filler in accordance with an embodiment of the present invention.

Fig. 5 is a block diagram showing a bi-directional satellite communication system using different frequencies in the up-line and down-line pilot signals in accordance with an embodiment of the present invention.

Fig. 6 is a flowchart describing a burst gain control method in the gap filler in accordance with an embodiment of the present invention.

### DESCRIPTION OF SPECIFIC EMBODIMENTS

The advantages, features and aspects of the invention will become apparent from the following description of the embodiments with reference to the accompanying drawings, which is set forth hereinafter. Therefore, those skilled in the field of this art of the present invention can embody the technological concept and scope of the invention easily. In addition, if it is considered that detailed description on a related art may obscure the points of the present invention, the detailed description will not be provided herein. The preferred embodiments of the present invention will be described in detail hereinafter with reference to the attached drawings.

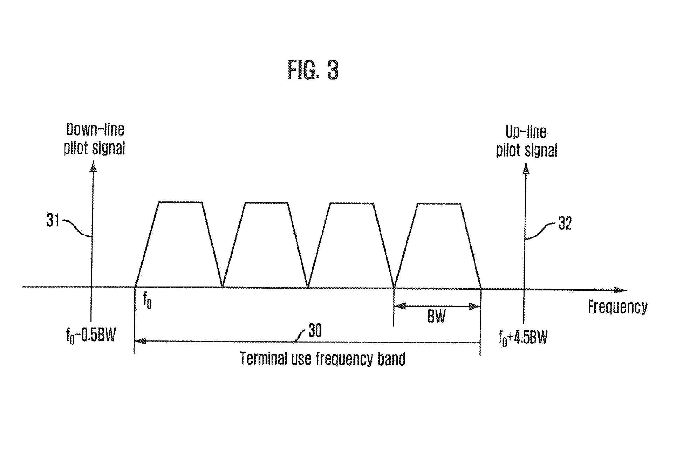

Fig. 3 shows a pilot signal divided into an up-line pilot signal and a down-line pilot signal inside a tunnel in accordance with an embodiment of the present invention.

In order to solve the problem generated when up/down high-speed trains coexist in the tunnel, as shown in Fig. 3, when the present invention uses the down-line frequency 31 of f₀-4.5BW and the up-line frequency 32 of f₀+4.5BW, which are different from each other, the gap filler sufficiently compensates for the gain with respect to each signal transmitted from the up and down terminals through burst automatic gain control (AGC) and can transmit the signal to a satellite. Herein, the down-line frequency 31 is a frequency of a pilot signal used by a mobile terminal located at the down moving object and the up-line frequency 32 is a frequency of a pilot signal used by a mobile terminal located at the up moving object. The pilot signal includes a tone signal and a modulation signal.

As shown in Fig. 3, the down-line pilot signal and the up-line pilot signal are symmetrically located outside a terminal use frequency band.

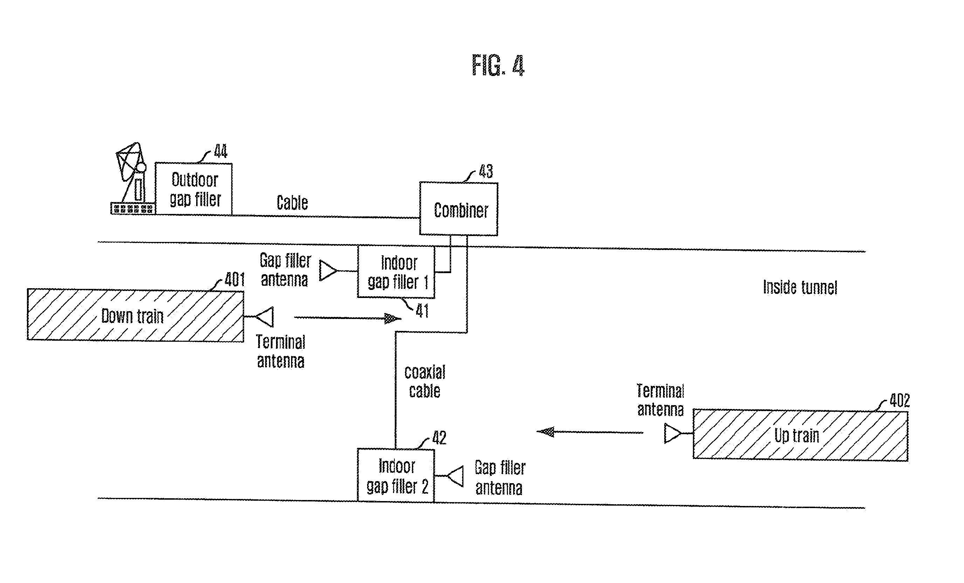

Fig. 4 shows a gap filler divided into an up-line gap filler and a down-line gap filler in accordance with an embodiment of the present invention.

When down and up trains 401 and 402 simultaneously passes through the tunnel, the present invention installs indoor gap filers 41 and 42 inside the tunnel individually into the up-line and the down-line for gain compensation of the burst signal.

Accordingly, the indoor gap filers 41 and 42 respectively receive the pilot signal from the mobile terminal of the train and control the gain of the burst signal. That is, the indoor gap filler 1 41 receives the pilot signal transmitted from the mobile terminal of the down train 401, i.e., the down-line pilot signal, and compensates for the gain of the burst signal. The indoor gap filler 2 42 receives the pilot signal transmitted from the mobile terminal of the up train 402, i.e., the up-line pilot signal, and compensates for the gain of the burst signal. The up-line pilot signal and the down-line pilot signal use frequencies which are different from each other.

One train creates and transmits an up-line pilot signal in case of the up line and a down-line pilot signal in case of the down line. After gain compensation in the indoor gap filler 1 41 and the indoor gap filler 2 42, each burst signal is transmitted to a combiner 43. Subsequently, the combiner 43 combines the burst signal transmitted from the indoor gap filler 1 41 and the indoor gap filler 2 42 and transmits the burst signal to an outdoor gap filler 44. Subsequently, the outdoor gap filler 44 transmits the combined burst signal to the satellite.

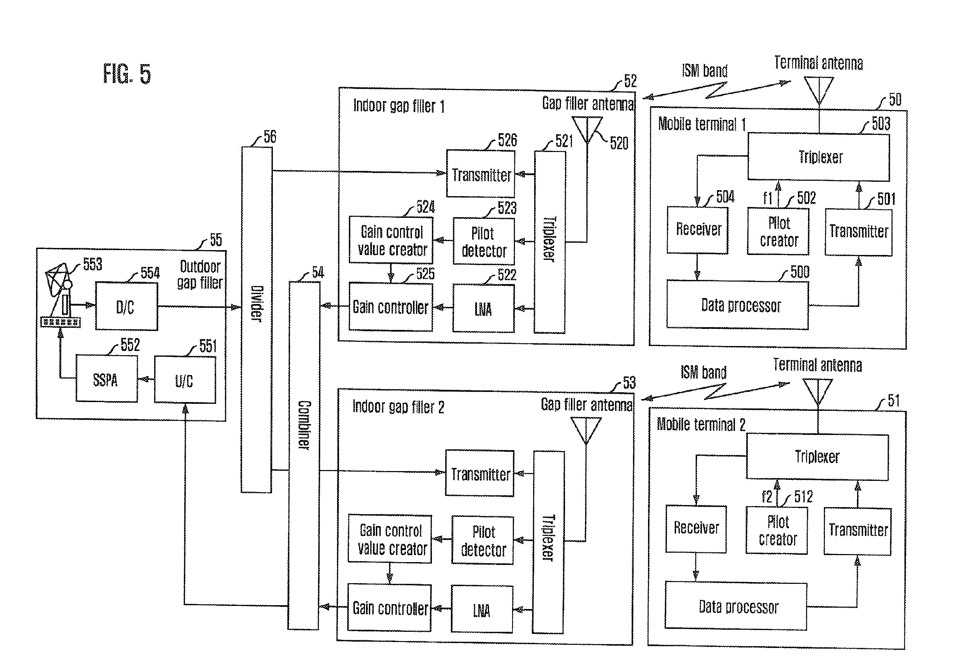

Fig. 5 is a block diagram showing a bi-directional satellite communication system using different frequencies in the up-line and down-line pilot signals in accordance with an embodiment of the present invention.

The bi-directional satellite communication system in accordance with the present invention includes a mobile terminal 1 50 located in the down train, a mobile terminal 2 51 located in the up train, an indoor gap filler 1 52 inside the tunnel receiving a signal from a mobile terminal 1, an indoor gap filler 2 53 inside the tunnel receiving a signal from a mobile terminal 2, a combiner 54, an outdoor gap filler 55, and a divider 56. The indoor gap filler 1 52, the indoor gap filler 2 53, the combiner 54, the outdoor gap filler 55, and the divider 56 are a portion corresponding to a gap filler. According to embodiments, the gap filler may include a single system.

First, the mobile terminal 1 50 and the mobile terminal 2 51 located in the moving object, e.g., a high-speed train, will be described.

The mobile terminal 1 50, as shown in Fig. 5, includes a data processor 500, a transmitter 501, a pilot creator 502, a triplexer 503, and a receiver 504. The mobile terminal 1 50 transmits a signal to the indoor gap filler 1 52 or receives and processes the signal transmitted from the indoor gap filler 1 52. The transmitter 501, the pilot creator 502, and the triplexer 503 corresponding to a multiplexer is a portion for transmitting a pilot signal for gain control of the burst signal in a satellite dead spot. The transmitter 501, the pilot creator 502, and the triplexer 503 do not finally control the gain of the burst signal but perform a part of the entire control procedures of the burst signal gain control. Accordingly, they may be called a burst gain control apparatus in the mobile terminal 1 50. Each constituent element of the transmitter 501, the pilot creator 502, and the triplexer 503 will be described hereinafter.

The data processor 500 transmits transmission data inputted or selected by the user to the transmitter 501 or processes and provides reception data recovered in the receiver 504 to the user. Subsequently, the transmitter 501 creates a burst signal for the transmission data transmitted from the data processor 500.

Meanwhile, the pilot creator 502 creates a pilot signal to be transmitted together with the burst signal created in the transmitter 501. That is, the pilot creator 502 creates and inserts the pilot signal into a neighboring frequency of the use frequency band, i.e., the terminal use band.

Subsequently, the triplexer 503 multiplexes the burst signal created in the transmitter 501 and the pilot signal created in the pilot creator 502 and transmits the burst signal and the pilot signal to the indoor gap filler 1 52. When the triplexer 503 transmits the burst signal and the pilot signal from the mobile terminal 50 to the indoor gap filler 1 52, the triplexer 503 corresponds to the multiplexer.

Meanwhile, the triplexer 503 of the mobile terminal 1 50 receives data transmitted from the indoor gap filler 1 52 and transmits the data to the receiver 504. The data processor 500 processes and provides the transmitted reception data to the user.

The configuration of the mobile terminal 1 50 described above is the same as that of the mobile terminal 2 51. Only, the mobile terminal 1 50 and the mobile terminal 2 51 have a difference in the pilot creators 502 and 512. That is, a frequency f₁ of the pilot signal created in the pilot creator 502 of the mobile terminal 1 50 should be different from a frequency f₂ of the pilot signal created in the pilot creator 512 of the mobile terminal 2 51 (see Fig. 3).

The mobile terminal located in a predetermined train operates as the mobile terminal 1 50 in case of the down line and the mobile terminal 2 51 in case of the up line.

The indoor gap filler 1 52 and the indoor gap filler 2 53 will be described in detail. Since the indoor gap filler 1 52 and the indoor gap filler 2 53 have the same configuration and perform the same function, only the indoor gap filler 1 52 will be described.

The indoor gap filler 1 52, as shown in Fig. 5, includes a gap filler antenna 520, a triplexer 521, a low noise amplifier (LNA) 522, a pilot detector 523, a gain control value creator 524, and a gain controller 525. The indoor gap filler 1 52 receives the signal transmitted from the mobile terminal 1 50 and transmits the signal to the combiner 54 after controlling the gain or transmits the signal divided by the divider 56 to the mobile terminal 1 50.

The triplexer 521, the pilot detector 523, the gain control value creator 524, and the gain controller 525 are a portion for controlling the gain of the burst signal based on a reverse direction signal transmitted from the mobile terminal 1 50. This portion including the triplexer 521, the pilot detector 523, the gain control value creator 524, and the gain controller 525 is called as a burst gain control unit. Also, the burst gain control unit in the indoor gap filler 1 52 and the indoor gap filler 2 53 of the repeaters 52 to 56 and the combiner 54 are a portion for controlling the gain of the burst signal based on the reverse direction signal individually transmitted from the mobile terminal 1 50 and the mobile terminal 2 51. This portion including the burst gain control unit and the combiner 54 is called as a burst gain control apparatus in the gap fillers 52 to 56.

A case that the indoor gap filler 1 52 receives the signal transmitted from the mobile terminal 1 50 and transmits the signal to the combiner 54 after gain control will be described.

The triplexer 521 divides the signal received through the gap filler antenna 520, i.e., the signal transmitted from the mobile terminal 1 into the pilot signal and the burst signal, outputs the pilot signal to the pilot detector 523 and outputs the burst signal to the LNA 522. In this case, the triplexer 521 corresponds to a signal dividing unit.

The pilot detector 523 detects and transmits the pilot signal to the gain control value creator 524. The gain control value creator 524 measures signal strength of the detected pilot signal, compares the signal strength with a pre-determined threshold, and creates a gain control value of the burst signal according to the comparison result, i.e., attenuation.

The gain controller 525 controls the gain of the burst signal outputted from the LNA 522 based on the gain control value created in the gain control value creator 524. The LNA 522 removes and amplifies noise of the burst signal divided by the triplexer 521.

Subsequently, the combiner 54 combines the gain-controlled burst signals outputted from the indoor gap filler 1 52 and the indoor gap filler 2 53 and transmits the combined burst signals to the outdoor gap filler 55.

When an up-converter (U/C) 551 of the outdoor gap filler 55 up-converts the frequency of the burst signals combined through the combiner 54, a solid state power amplifier (SSPA) 552 amplifies the burst signal of the up-converted frequency. The amplified and combined burst signal is transmitted to the satellite through a satellite transmission/reception antenna 553.

A case that the outdoor gap filler 55, the indoor gap filler 1 52 and the indoor gap filler 2 53 transmit the signal transmitted from the satellite to the mobile terminal 50 1 and the mobile terminal 2 51 will be described in brief.

When a down-converter (D/C) 554 performs frequency down conversion on the data signal received through the satellite transmission/reception antenna 553, the divider 56 divides the signal to be transmitted to the mobile terminal 1 50 and the mobile terminal 2 51 and transmits the signal to the indoor gap filler 1 52 and the indoor gap filler 2 53. Subsequently, a transmitter 526 of the indoor gap filler 1 52 amplifies and transmits the signal to the mobile terminal 1 50 through the triplexer 521 and the gap filler antenna 520. The indoor gap filler 2 53 performs the same function as the indoor gap filler 1 52.

According to the brief description on the operation of the present invention, when the mobile terminal 50 of the down-line train transmits the burst signal to the indoor gap filler 52, the mobile terminal 50 transmits the pilot signal continuously existing on a time axis at a neighboring frequency f₁ of an allocated use frequency band. On the other hand, when the mobile terminal 51 of the up-line train transmits the burst signal to the indoor gap filler 53, the mobile terminal 51 transmits the pilot signal continuously existing on the time axis at a neighboring frequency f₂ of the allocated use frequency band.

Each of the indoor gap fillers 52 and 53 detects the pilot signal transmitted from the up and down mobile terminals and controls the gain of the burst signal through the attenuation of the signal strength. The gain-controlled burst signal is combined in the combiner 54 and then transmitted to the satellite through the outdoor gap filler 55.

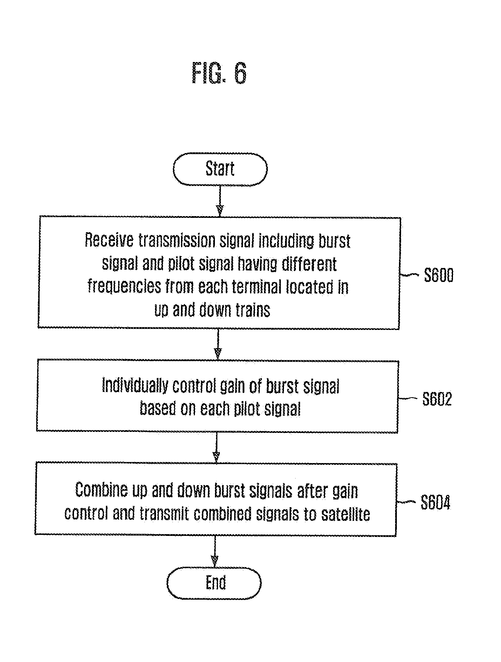

Fig. 6 is a flowchart describing a burst gain control method in the gap filler in accordance with an embodiment of the present invention. In particular, Fig. 6 shows the burst gain control method performed in the burst gain control apparatus of the gap filler.

At step S600, the gap fillers 52 to 56 receive the reverse direction signal, i.e., the transmission signal including the burst signal and the pilot signal having the different frequencies, from the up mobile terminal located in the up train and the down mobile terminal located in the down train.

At step S602, the gap fillers 52 to 56 control the gain of the burst signal based on each pilot signal. That is, the gap fillers 52 to 56 control the gain of the up burst signal based on the up-line pilot signal transmitted from the up mobile terminal and control the gain of the down burst signal based on the down-line pilot signal transmitted from the down mobile terminal.

At step S604, the gap fillers 52 to 56 combine the up burst signal and the down burst signal after gain control and transmit the combined signals to the satellite.

As described above, the technology of the present invention can be realized as a program. A code and a code segment forming the program can be easily inferred from a computer programmer of the related field. Also, the realized program is stored in a computer-readable recording medium, i.e., information storing media, and is read and operated by the computer, thereby realizing the method of the present invention. The recording medium includes all types of recording media which can be read by the computer.

When the satellite communication system based on Digital Video Broadcasting-Return Channel via Satellite (DVB-RCS) standard provides the satellite communication service using the burst signal, the present invention described above can sufficiently compensate for the gain without deterioration of the performance in two burst signals transmitted from the up and down trains although the up and down trains moving at high-speed coexist in the dead spot such as the tunnel.

That is, the present invention can sufficiently compensate for the gain of the burst signal transmitted from each mobile terminal even in a case where the up and down trains coexist since the up and down mobile terminals transmit the pilot signals having different frequencies.

While the present invention has been described with respect to the specific embodiments, it will be apparent to those skilled in the art that various changes and modifications may be made without departing from the spirit and scope of the invention as defined in the following claims.

## Claims

1. An apparatus for controlling a burst gain in a mobile terminal, comprising:
a transmission means for creating a burst signal for transmission data;
a pilot creating means for creating a pilot signal located outside a use frequency band of the mobile terminal where the pilot signals have different frequencies according to the direction of the mobile terminal; and
a multiplexing means for multiplexing and transmitting the burst signal and the pilot signal to a gap filler.

2. The apparatus of claim 1, wherein the pilot creating means respectively creates an up-line pilot signal and a down-line pilot signal when the mobile terminal is located in a train.

3. The apparatus of claim 2, wherein the pilot creating means creates the up-line or down-line pilot signal such that any one of the up-line and down-line pilot signals can be located in an upper band outside the use frequency band and the other can be located at a lower band.

4. The apparatus of claim 1, 2, or 3, wherein the gap filler is a gap filler for satellite communication installed at a dead spot of a satellite where a bi-directional moving object progresses.

5. An apparatus for controlling a burst gain in a gap filler, comprising:
a burst gain control means for receiving a transmission signal including a burst signal and a pilot signal having frequencies, which are different according to a moving direction, from a plurality of mobile terminals and individually controlling the gain of the burst signal based on each pilot signal; and
a combining means for combining a plurality of burst signals after individual gain control in the burst gain control means.

6. The apparatus of claim 5, wherein the burst gain control means includes:
a first burst gain control unit for receiving a first transmission signal including a first pilot signal and a first burst signal from a first mobile terminal and controlling the gain of the first burst signal based on the first pilot signal; and
a second burst gain control unit for receiving a second transmission signal including a second pilot signal and a second burst signal having a frequency, which is different from that of the first pilot signal, from a second mobile terminal.

7. The apparatus of claim 6, wherein each of the first and second burst gain control units measures signal strength of the pilot signals, acquires attenuation by comparing the measured signal strength with a predetermined threshold, and creates a gain control value of the burst signal according to the attenuation.

8. The apparatus of claim 6 or 7, wherein the first mobile terminal is a mobile terminal located in an up train and the second mobile terminal is a mobile terminal located in a down train.

9. The apparatus of one of claims 5 to 8, wherein the gap filler is a gap filler for satellite communication located in a satellite dead spot.

10. A method for controlling a burst gain in a mobile terminal, comprising:
creating a burst signal for transmission data;
creating a pilot signal located outside a use frequency band of the mobile terminal where the pilot signal has different frequencies according to the direction of the mobile terminal; and
multiplexing and transmitting the burst signal and the pilot signal to a gap filler.

11. The method of claim 10, wherein in said creating a pilot signal, when the mobile terminal is located in a train, the pilot signal is created respectively into an up-line pilot signal and a down-line pilot signal.

12. The method of claim 11, wherein in said creating a pilot signal, any one of the up-line and down-line pilot signals is created to be located in an upper band outside the use frequency band and the other is created to be located in a lower band.

13. A method for controlling a burst gain in a gap filler, comprising:
receiving a transmission signal including a burst signal and a pilot signal having different frequencies according to a mobile direction from a plurality of mobile terminals;
individually controlling the gain of the burst signal based on each pilot signal; and
combining a plurality of burst signals after gain control.

14. The method of claim 13, wherein said receiving a transmission signal includes:
receiving a first transmission signal including a first burst signal and a first pilot signal from a terminal located in an up train; and
receiving a second transmission signal including a second burst signal and a second pilot signal from a terminal located in a down train.

15. The method of claim 14, wherein said controlling the gain of the burst signal includes:
controlling the gain of the first burst signal based on the first pilot signal; and
controlling the gain of the second burst signal based on the second pilot signal.

16. The method of claim 15, wherein said controlling the gain of the first and second burst signal includes:
measuring signal strength of the pilot signals;
acquiring attenuation by comparing the measured signal strength with a predetermined threshold;
creating a gain control value of the burst signal according to the attenuation; and
controlling the gain of the burst signal based on the gain control value.
